# EUROPEAN PATENT APPLICATION

(11) **EP 4 841 635 A1**
(43) Date of publication of application: **18.11.2026**
(21) Application number: 25755163.0
(22) Date of filing: 03.02.2025
(51) Int. Cl.: G11C 15/04, G06N 3/02

(54) **ANALOG DATA SIMILARITY SEARCH MEMORY DEVICE AND OPERATING METHOD THEREOF**

(30) Priority: 15.02.2024 KR 20240021797
(71) Applicant: Seoul National University R&DB Foundation, Seoul 08826 (KR)
(72) Inventor: KIM, Sangbum, Seoul 08826 (KR); JOE, Changhoon, Seoul 08826 (KR); BYUN, Kanghyeon, Seoul 08826 (KR)
(74) Representative: Isarpatent
(86) International application number: PCT/KR2025/099172
(87) International publication number: WO 2025/174166

(57) **Abstract**

An analog data similarity search memory device and a method of operating the same are disclosed. The disclosed analog data similarity search memory includes a data storage block that stores an analog input voltage and is connected to a first terminal of a data line; and a matching block that is connected to a second terminal of the data line and includes a match line that outputs an analog matching distance value corresponding to a voltage difference between the analog input voltage and an analog search voltage applied via the search line, wherein the voltage difference between the analog input voltage and the analog search voltage may be generated via the data line.

## Description

### TECHNICAL FIELD

The present invention relates to content-addressable memory (CAM), and more particularly to an analog data similarity search memory device and a method of operating the same.

### BACKGROUND ART

Content addressable memory (CAM) is a specialized type of computer memory used in certain ultra-fast search applications, also known as associative memory or associative storage, that compares input search data with a table of stored data and returns the address of the matching data. CAM is used in network devices such as routers, switches, and cache memory to speed up the manipulation of forwarding information bases and routing tables. Ternary Content-Addressable Memory (TCAM) is an extension of CAM, in which CAM stores two values, 0 and 1, while TCAM may store three values, 0, 1, and "don't care". Further, the TCAM comprises a plurality of TCAM cells, each of which is connected with a search line and a match line, and compares the search value input through the search line with the data value stored in the cell, and outputs a binary signal such as a match or a mismatch through the match line.

Meanwhile, statistics, data mining, and machine learning commonly use distance functions to quantify the similarity between data. In particular, machine learning uses a variety of distance functions to measure the distance and similarity between data vectors, such as cosine distance, hamming distance, and Euclidean distance.

In conventional deep learning applications, CAMs or TCAMs are used to mimic Hamming distance in hardware to perform distance computation and nearest neighbor search in parallel. However, the binary data vector-based Hamming distance computation is difficult to apply to backpropagation, a differential-based neural network training method. Backpropagation is to calculate the gradient (derivative) of the input value with respect to the output value from the output layer and propagate it to the input layer.

In other words, conventional CAMs and TCAMs output binary digital data through the match line that only indicates whether it is a match or a mismatch, so it is difficult to measure the similarity between vectors for nearest neighbor detection, and it is difficult to apply the function of the distance function using CAM or TCAM that may be applied to backpropagation, a differential-based neural network training method.

In addition, conventional static RAM (SRAM)-based TCAMs require 16 metal oxide semiconductor field effect transistors (MOSFETs), which increases the cost and limits mass production and large-scale array fabrication due to the large cell size.

In addition, for deep learning applications, it is necessary to calculate the distance between vectors with real values, but in the case of conventional CAM or TCAM, it is impossible to calculate the distance between vectors with real values because it stores/retrieves/outputs binary values (1,0).

Although conventional analog CAMs have a limited range of real numbers to which the input analog values may be matched, only a limited range of real numbers may be compared, and the value output on the match line is a binary value that indicates whether the analog value is present or absent in the range. Therefore, the Hamming distance using a conventional analog CAM maynot be differentiated by computing the distance between discrete vectors. This makes it difficult to apply the distance output from the match line to a loss function to train a neural network. In order to use the Hamming distance calculated by conventional TCAMs in a one-shot learning algorithm, the real-valued vector output from the neural network must be binarized, which requires an additional block and introduces losses due to binarization.

Therefore, it is necessary to study an analog input data similarity search device that has a distance function capable of measuring the similarity between vectors for nearest neighbor search, reduces the area size, and is applicable to backpropagation, a neural network training method based on a real-valued distance operation between vectors.

### DISCLOSURE OF THE INVENTION

### TECHNICAL PROBLEM

The technical problem of the present invention is to provide an analog input data similarity search device having a distance function capable of measuring the similarity between vectors for nearest neighbor detection, reducing the area size, and providing a real output value applicable to backpropagation, a neural network training method based on a real-valued inter-vector distance operation.

Further, the technical challenge of the present invention is to provide a method of operating the above analog data similarity search memory element.

The problems that the present invention is intended to solve are not limited to those mentioned above, and other problems not mentioned will be understood by those skilled in the art from the following description.

### TECHNICAL SOLUTION

According to one embodiment of the present invention, there may be provided an analog data similarity search memory device comprising: a data storage block, which stores an analog input voltage and is connected to a first terminal of a data line; and a matching block, which is connected to a second terminal of the data line and outputs an analog matching distance value corresponding to a voltage difference between the analog input voltage and an analog search voltage applied via the data line.

In one embodiment, the matching block comprises a first transistor having a first dual gate and a second transistor having a second dual gate, the data storage block may comprise a capacitor comprising a first terminal of the data line and a second terminal connected to ground, and a third transistor connected to the first terminal of the capacitor and supplying the analog input voltage to the capacitor. The data storage block may further comprise a fourth transistor connected to the first terminal of the capacitor and supplying a reference voltage to the capacitor, wherein the I-V curves of the transistors of the matching block may be zero-offset according to an off current (I_{off}) output based on the reference voltage. A first gate terminal of the first transistor and a third gate terminal of the second transistor are connected with the first gate terminal of the capacitor to form the data line, and a second gate terminal of the first transistor and a fourth gate terminal of the second transistor may be coupled with the search line. The first drain terminal of the first transistor and a second drain terminal of the second transistor connected with the first drain terminal form the match line, which may be connected to ground. The first source terminal of the first transistor and the second source terminal of the second transistor connected to the first source terminal are connected to a supply voltage source, and the voltage supplied from the supply voltage source may offset a difference between a first threshold voltage of the first transistor and a second threshold voltage of the second transistor. The first transistor may be a PMOS (P-type MOSFET) transistor, the second transistor may be an NMOS (N-type MOSFET) transistor, the third transistor and the fourth transistor may be IGZO (InGaZnO) transistors. The analog matching distance value may be larger for a larger difference between the analog input voltage and the analog search voltage, and smaller for a smaller difference between the analog input voltage and the analog search voltage.

In another embodiment, the matching block may comprise a first transistor and a second transistor, and the data storage block comprises a capacitor having a capacitance corresponding to the analog input voltage, the capacitor including a first terminal of the data line and a second terminal connected to the search line, and a third transistor connected to the first terminal of the capacitor and supplying the analog input voltage to the capacitor. The data storage block may further comprise a fourth transistor connected to the first terminal of the capacitor and supplying a reference voltage to the capacitor, wherein the I-V curves of the transistors comprising the matching block may be zero-offset according to an off current (I_{off}) output based on the reference voltage. A first gate terminal of the first transistor and a second gate terminal of the second transistor connected with the first gate terminal may be connected with a first terminal of the capacitor to form the data line, and a first drain terminal of the first transistor and a second drain terminal of the second transistor connected with the first drain terminal may form the match line, and may be connected to ground. The first source terminal of the first transistor and the second source terminal of the second transistor connected with the first source terminal are connected to a supply voltage source, and the voltage supplied from the supply voltage source may offset a difference between a first threshold voltage of the first transistor and a second threshold voltage of the second transistor. The first transistor may be a PMOS (P-type MOSFET) transistor, the second transistor may be an NMOS (N-type MOSFET) transistor, the third transistor and the fourth transistor may be IGZO (InGaZnO) transistors.

In another embodiment, the matching block comprises a first transistor and a second transistor, wherein the data storage block comprises a first sub-data storage block associated with the first transistor and a second sub-data storage block associated with the second transistor, wherein the first sub-data block includes a first capacitor having a first terminal of the first data line and a second terminal coupled to the search line, and a third transistor connected to the first terminal of the first capacitor and supplying the first analog input voltage to the first capacitor, and the second sub-data block may include a second capacitor having a first terminal of a second data line and a second terminal coupled to the search line, and a fourth transistor connected to a first terminal of the second capacitor and supplying the second analog input voltage to the second capacitor. The first data storage block may be connected to a first terminal of the first capacitor and further comprises a fifth transistor supplying a reference voltage to the first capacitor, and wherein the second data storage block is connected to a first terminal of the second capacitor and further comprises a sixth transistor supplying a reference voltage to the second capacitor, and wherein the I-V curves of the transistors comprising the matching block are zero-offset by using a reference analog matching distance value output based on the reference voltage. A first gate terminal of the first transistor is connected with a first terminal of the first capacitor to form the first data line, a third gate terminal of the second transistor is connected with a first terminal of the second capacitor to form the second data line, and a first drain terminal of the first transistor and a second drain terminal of the second transistor connected with the first drain terminal form the match line, and may be connected to ground. A first source terminal of the first transistor and a second source terminal of the second transistor connected with the first source terminal are connected to a supply voltage source, and a voltage supplied from the supply voltage source may offset a difference between a first threshold voltage of the first transistor and a second threshold voltage of the second transistor. The first transistor and the second transistor may be N-type MOSFET (NMOS) transistors, and the third transistor, the fourth transistor, the fifth transistor, and the sixth transistor may be InGaZnO (IGZO) transistors. The analog matching distance value may be backpropagated and used to update an analog input voltage of the data storage block.

According to another embodiment of the present invention, a semiconductor memory device comprising an array of the described analog data similarity search memory elements may be provided.

According to another embodiment of the present invention, a method of operating an analog data similarity search memory device comprising: a data storage block connected with a first terminal of a data line; and a matching block connected with a search line and a match line and connected with a second terminal of the data line, the method comprising: storing in the data storage block an analog input voltage corresponding to a real value of a corresponding feature point; receiving an analog search voltage via a search line; and outputting an analog matching distance value corresponding to a voltage difference between the analog input voltage and the analog search voltage via a match line, wherein a voltage difference between the analog input voltage and the analog search voltage is generated via the data line. The method may further comprise the step of performing a zero offset of the I-V curves of the transistors including the matching block, or the step of updating the analog input voltage of the data storage block by backpropagating the analog matching distance value.

### ADVANTAGEOUS EFFECTS

According to embodiments of the present invention, in performing a matching distance operation between stored data and search data, an analog data similarity search memory element may convert an input value into a voltage and apply it to a data line (DL) and a search line (SL) to output a distance between successive input values (voltages) in the form of a differentiable current, and a current may be output through a match line (ML) equal to the difference between the stored data value and the search data value to enable comparison between real values, and the resulting value may be applied to a distance function to improve learning accuracy.

In addition, by using up to four transistors to implement the analog data similarity search memory device, the size of the device may be reduced, and the area of the device may be minimized when implementing an array of devices, facilitating mass production.

Furthermore, by using capacitors in the data storage block to store analog values in the device, data may be stored at a finer granularity than in conventional devices.

According to one embodiment of the present invention, a method of operation of an analog data similarity search memory device having the aforementioned advantages may be provided.

However, the effects of the present invention are not limited to the above effects, and may be variously extended without departing from the technical ideas and scope of the present invention.

### BRIEF DESCRIPTION OF THE DRAWINGS

FIG. 1 illustrates a concept of operation of a semiconductor memory device according to one embodiment of the present invention.
FIGS. 2A and 2B illustrate an analog data similarity search memory according to one embodiment of the present invention, and FIG. 2C is a graph illustrating an output value of a matching distance as a function of a voltage difference between a data line and a search line in the analog data similarity search memory of FIGS. 2A and 2B.
FIG. 3 illustrates a variation of a threshold voltage with a voltage supplied to a search line in an analog data similarity search memory in accordance with one embodiment of the present invention.
FIG. 4 is an I-V characteristic graph to illustrate how a threshold voltage difference between an NMOS transistor and a PMOS transistor of an analog data similarity search memory device according to one embodiment of the present disclosure may be offset.
FIG. 5 is an I-V characteristic graph to illustrate the principle of operation of a matching block of an analog data similarity search memory in accordance with one embodiment of the present disclosure.
FIGS. 6Aa and 6B are schematics for an analog data similarity search memory according to another embodiment of the present invention, and FIG. 6C is an I-V characteristic graph of the analog data similarity search memory of FIGS. 6A and 5B.
FIG. 7 illustrates the principle of operation of zero offsetting the I-V characteristic graph of an analog data similarity search memory device according to one embodiment of the present invention.
FIG. 8 is a schematic diagram of a semiconductor memory device comprising an NXM array of analog data similarity search memory elements according to one embodiment of the present invention.
FIGS. 9A and 9B are flow diagrams to illustrate a method of operation of an analog data similarity search memory device according to one embodiment of the present invention.
FIG. 10 is a schematic diagram for an analog data similarity search memory device according to another embodiment of the present invention.
FIGS. 11A and 11B are I-V characteristic graphs of an analog data similarity search memory device according to another embodiment of the present invention.
FIG. 12 is a schematic diagram of a semiconductor memory device comprising an NXM array of analog data similarity search memory elements according to another embodiment of the present invention.
FIGS. 13A and 13B illustrate an operation principle for zero offsetting an I-V characteristic graph of an analog data similarity search memory element according to one embodiment of the present invention.

### BEST MODE FOR CARRYING OUT THE INVENTION

Hereinafter, embodiments of the present invention will be described in detail with reference to the accompanying drawings.

The embodiments of the invention described below are provided for the purpose of more clearly illustrating the invention to those having ordinary skill in the art, and the scope of the invention is not intended to be limited by the following embodiments, which may be modified in various other ways.

The terms used in this specification are intended to describe particular embodiments and are not intended to limit the invention. Terms used herein in the singular form may include the plural form, unless the context clearly indicates otherwise. Furthermore, the terms "comprise" and/or "comprising" as used herein are intended to specify the presence of the mentioned shapes, steps, numbers, motions, absences, elements, and/or groups thereof, and are not intended to exclude the presence or addition of one or more other shapes, steps, numbers, motions, absences, elements, and/or groups thereof. Furthermore, as used herein, the term "connected" is intended to mean not only that certain elements are directly connected, but also that they are indirectly connected by the interposition of other elements between them.

Further, when the present disclosure refers to a member being located "on" another member, this includes not only when a member is abutting another member, but also when there is another member between the two members. As used herein, the term "and/or" includes any one of the enumerated items and any combination of one or more of them. In addition, the terms "about," "substantially," and the like as used in the disclosure are intended to mean at or near the range of numbers or degrees, taking into account inherent manufacturing and material tolerances, and to prevent infringers from taking unfair advantage of the disclosure where precise or absolute numbers are stated, which are provided for the purpose of illustration.

Embodiments of the present invention will now be described in detail with reference to the accompanying drawings. The sizes or thicknesses of the areas or parts shown in the accompanying drawings may be somewhat exaggerated for clarity and ease of description. Throughout the detailed description, like reference numerals designate like components.

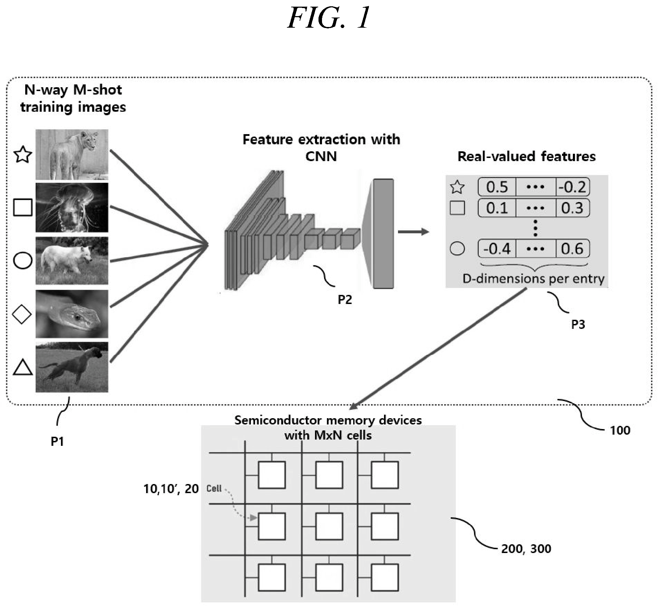

FIG. 1 illustrates a concept of operation of a semiconductor memory device according to one embodiment of the present invention.

Referring to FIG. 1, a processor, typically a central processing unit CPU or a graphic processing unit GPU, may execute an executable program or application to extract features, each represented by a real-valued vector P3, from a set of training images P1. Specifically, a convolutional neural network CNN model P2 may be provided with training images as input and output the real-valued vectors of those training images as output. An N-way may be defined as a training set comprising an integer N classes, and n-shots may be defined as the number of samples in each class. For example, in FIG. 1, a first realized vector may be determined for a training image (☆), a second realized vector may be determined for a training image (□), a third realized vector may be determined for a training image (∘), a fourth realized vector may be determined for a training image (◇), a fifth realized vector may be determined for a training image (△). The processor may generate D-dimensional real vectors representing features of the training images. Non-limitingly, the number of training images may be five or more.

The real vectors obtained through training may then be stored and updated in the semiconductor memory devices 200, 300 having M x N cells of the present invention. In the case of a conventional digital-CAM or multibit-CAM, it is difficult to store a real vector in analog form in a cell (corresponding to an analog data similarity search memory element to be described later), so the real vector is quantized and stored in the cell. However, in the present invention, when the real vectors are stored in the array of semiconductor memory devices 200, 300, they may be programmed using voltages corresponding to analog values, respectively. A detailed operational description of the semiconductor memory devices 200, 300 will be described later.

When the semiconductor memory devices 200, 300 trained by a processor such as a CPU or GPU are provided with the extracted real vector value corresponding to the query image as a search value, the semiconductor memory devices 200, 300 perform a search and output an image (☆) that closely resembles the real vector value of the query image, which is the basic role of neuromorphic semiconductors.

However, in the case of conventional CAMs, the distance value to determine similarity is output as a binary value, which is difficult to apply to train a CNN that performs feature extraction. The semiconductor memory devices 200, 300 comprising an array of analog data similarity search memory devices 10, 10', 20, 20', 30 according to the present invention receive analog input values and output analog distance values (currents), which may be applied to the error function of the CNN and used to train the CNN.

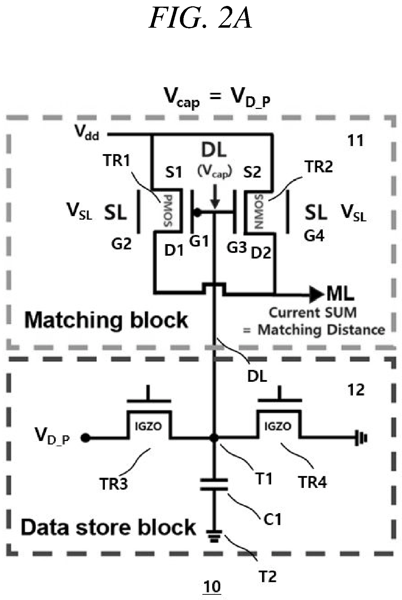

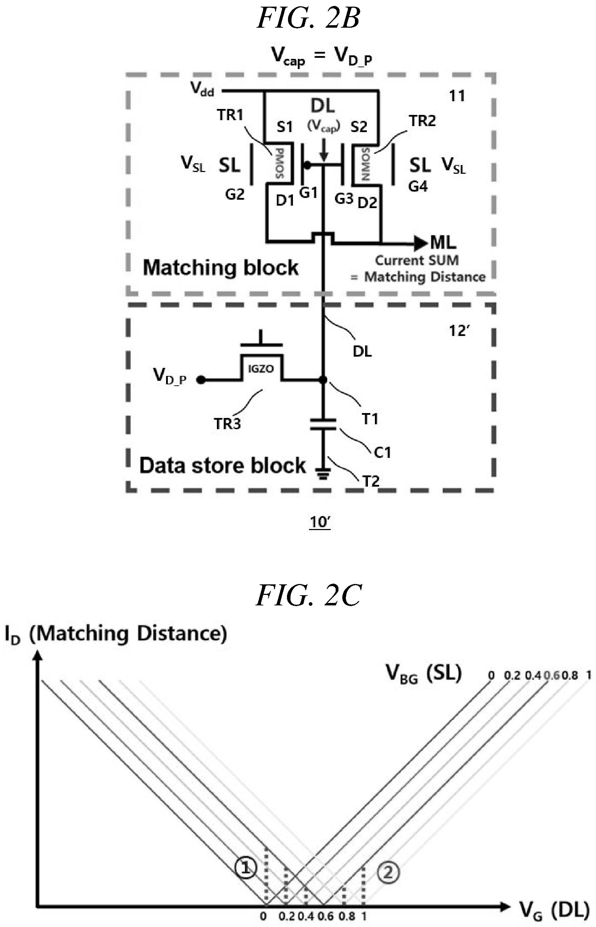

FIGS. 2A and 2B are circuit diagrams for an analog data similarity search memory device 10, 10' according to one embodiment of the present invention, and FIG. 2C is a graph representing an output value of a matching distance based on a voltage difference between a data line and a search line of the analog data similarity search memory devices 10, 10' of FIGS. 2A and 2B.

Referring to FIG. 2A, the analog data similarity search memory device 10 may comprise a matching block 11 and a data storage block 12. The analog data similarity search memory device 10 may output a distance between successive input data (or voltages) in the form of a differentiable current when performing a matching distance operation between the data stored in the data storage block 12 and the search data input via the matching block 11.

Specifically, the analog data similarity search memory device 10 stores the analog input pre voltage V_{D_P} , and connects a data storage block 12 connected to a first terminal of the data line DL and a second terminal of the data line DL, and comprises a matching block 11 that may include a search line SL receiving the analog search voltage V_{SL} and a match line ML outputting an analog matching distance value corresponding to a voltage difference (V_{D_P} - V_{SL}) between the analog input voltage V_{D_P} and the analog search voltage V_{SL}. The analog input voltage V_{D_P} may be a voltage corresponding to a value of one of the real vectors representing feature points of the training image described above. The analog search voltage V_{SL} may be a voltage corresponding to a value of one of the real-valued vectors representing feature points of the query image.

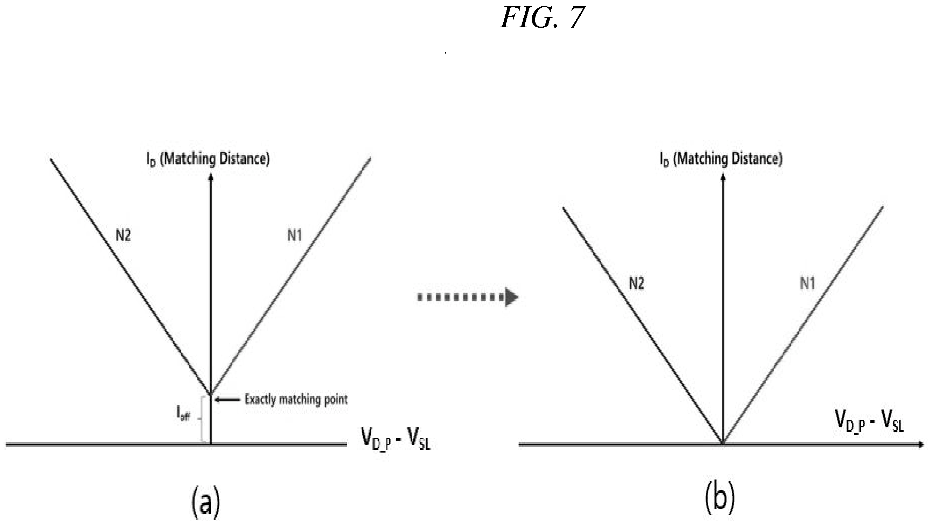

A voltage difference (V_{D_P} - V_{SL}) between the analog input voltage V_{D_P} and the analog search voltage V_{SL} may be generated via the data line DL. Here, the analog input voltage V_{D_P} is a voltage corresponding to a real value of one of the real vectors of the training image obtained through the training process of FIG. 1 before the analog search voltage V_{SL} is input, and may be stored in the capacitor C1 to be described later. Then, when the analog search voltage V_{SL} is input via the search line SL, a voltage difference (V_{D_P} - V_{SL}) is generated on the data line DL. Specifically, the matching block 11 may comprise a first transistor TR1 having a first dual gate G1, G2 and a second transistor TR2 having a second dual gate G3, G4. In addition, the data storage block 12 has a capacitance corresponding to the analog input voltage V_{D_P}, a capacitor C1 including a first terminal T1 defined as a first terminal of the data line DL1 and a second terminal T2 connected to ground, and a third transistor TR3 that supplies the analog input voltage V_{D_P} to the capacitor C1 and is connected to the first terminal of the capacitor C1, may include a fourth transistor TR4 supplying a reference voltage to the capacitor C1. The I-V curves of the transistors comprising the matching block 11 may be zeroed offset using an off current I_{off} output based on the reference voltage, as will be described later in FIG. 7. The off current I_{off} is the drain current I_{D} that flows when the analog search voltage V_{SL} is 0 V after setting the voltage stored in the capacitor C1 to a reference voltage of 0 V.

In addition, the first gate terminal G1 of the first transistor TR1 of the matching block 11 and the third gate terminal G3 of the second transistor TR2 connected with the first gate terminal G1 may be connected with the first terminal T1 of the capacitor C1 to form a data line DL. The second gate terminal G2 of the first transistor TR1 and the fourth gate terminal G4 of the second transistor TR2 may be coupled with the search line SL. The first drain terminal D1 of the first transistor TR1 and the second drain terminal D2 of the second transistor TR2 connected with the first drain terminal D1 form a match line ML, which may be coupled to the second terminal T2 of the capacitor C1 or to ground. And the first source terminal S1 of the first transistor TR1 and the second source terminal S2 of the second transistor TR2, which is connected to the first source terminal S2, may be connected to a supply voltage source. The second gate terminal G2 of the first transistor TR1 and the fourth gate terminal G4 of the second transistor TR2 correspond to a back gate, and the first gate terminal G1 of the first transistor TR1 and the third gate terminal G3 of the second transistor TR2 correspond to a top gate. Alternatively, the second gate terminal G2 and the fourth gate terminal G4 may be top gates and the first gate terminal G1 and the third gate terminal G3 may be back gates.

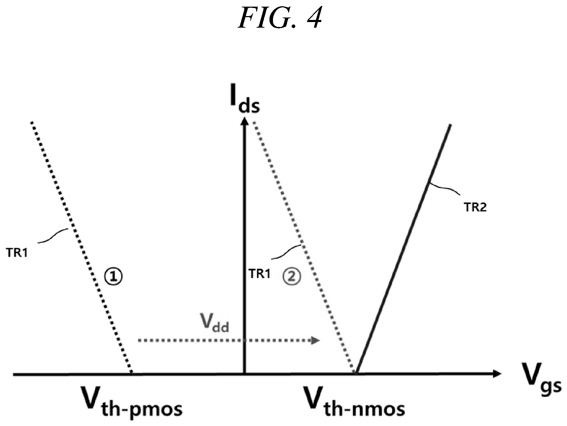

The supply voltage source is a supply voltage V_{dd}, which may be a voltage difference between a first threshold voltage Vₜₕ₋ₚₘₒₛ of the first transistor TR1 and a second threshold voltage Vₜₕ₋ₚₘₒₛ of the second transistor TR2, with reference to FIG. 4 hereinafter. The voltage difference between the first threshold voltage Vₜₕ₋ₚₘₒₛ of the first transistor TR1 and the second threshold voltage Vₜₕ₋ₚₘₒₛ of the second transistor TR2 is the voltage supplied to the source terminals of the first transistor TR1 and the second transistor TR2, The voltage difference between the first threshold voltage Vₜₕ₋ₚₘₒₛ of the first transistor TR1 and the second threshold voltage Vₜₕ₋ₚₘₒₛ of the second transistor TR2 may be canceled out to produce a symmetrical I-V characteristic graph. Non-limitingly, the first transistor TR1 may be a PMOS (P-type MOSFET) transistor, the second transistor TR2 may be an NMOS (N-type MOSFET) transistor, and the third transistor TR3 and the fourth transistor TR4 may be IGZO (InGaZnO) transistors. Further, the analog matching distance value output via the match line ML is a current I_{D} corresponding to the voltage difference V_{D_P} - V_{SL}, such that the larger the voltage difference V_{D_P} - V_{SL}, the larger the current I_{D}, and the smaller the voltage difference V_{D_P} - V_{SL}, the smaller the current I_{D}.

One of the important roles of the data storage block 12 is to store the desired voltage value in the capacitor C1 for a long period of time, so that the desired V_{cap} (=V_{D_P}) value is maintained in all unit cells in the array, e.g., the analog data similarity search memory element 10, until searching is performed. It is also important to store the desired voltage value of V_{cap} (=V_{D_P}) in the capacitor C1 accurately without a separate write/verify process. In order for the voltage value V_{cap} (=V_{D_P}) stored in capacitor C1 to be maintained for a long time, since V=Q/C, the capacitance must be increased or the charge loss must be reduced. In the former case, there is a limit to enlarging the plate area of capacitor C1, so the overall charge loss must be reduced. For this purpose, it is preferable to use IGZO-based transistors with low leakage current. The IGZO transistor has a leakage current that is 3 to 6 orders of magnitude lower than that of a conventional transistor, thus ensuring a longer retention time of the stored voltage.

General resistor-based memory devices are not easy to program with accurate values, so they need to be verified after every write. Therefore, it is necessary to minimize the write/verify process because the time required increases exponentially as the number of programming steps increases. Therefore, for this purpose, the desired voltage V_{D_P} is applied to the capacitor C1 connected to the data line DL and the transistor TR3 connected to the capacitor C1 is turned on for a sufficient time, so that the desired DL value V_{cap} (=V_{D_P}) may be stored in the capacitor C1.

In the case of FIG. 2A, the analog data similarity search memory element 10 of FIG. 2A may be utilized in a structure in which the voltage application may not be quickly changed fluidly by grounding the first terminal T1 of the capacitor C1 through the fourth transistor TR4 of the data storage block 12, and storing the analog input voltage V_{D_P} in the capacitor C1 through the third transistor TR3. Optionally, in a structure in which the applied voltage may be changed quickly, only the third transistor TR3 may be used to ground the drain terminal of the third transistor TR3 so that the analog input voltage V_{D_P} is supplied, as shown in FIG. 2B.

In addition, the data storage block 12 may not include the fourth transistor TR4, as shown in FIG. 2B, if a zero offset is not required for the I-V curves of the transistors comprising the matching block 11, as shown in FIG. 7, to be described later. For a detailed description of FIG. 2b, reference may be made to the description of FIG. 2A, which excludes the fourth transistor TR4 of the data storage block 12, unless contradicted.

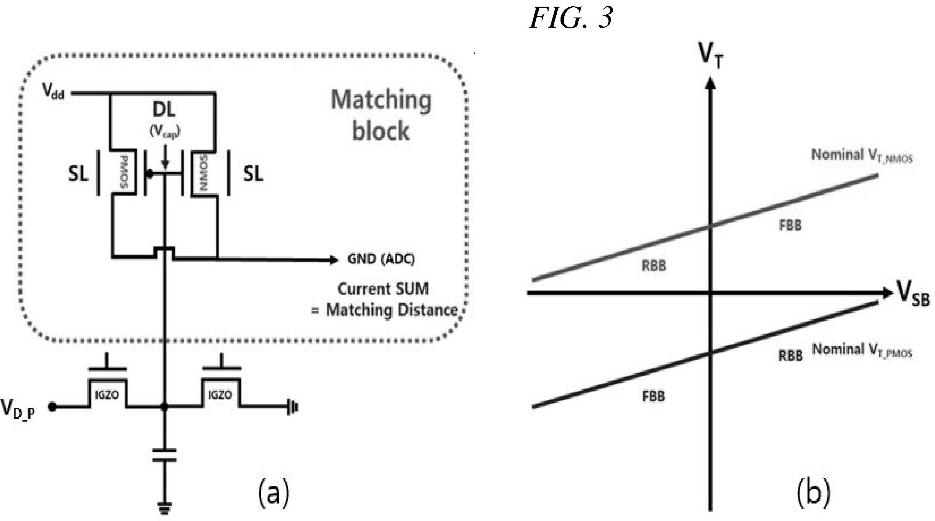

Referring again to FIGS. 2A and 2B, an analog input voltage V_{D_P} corresponding to data may be supplied to the capacitor C1 connected to the data line DL to store information. At this time, the second terminal T2 of the capacitor C1 is fixed to ground and the first terminal T1 of the capacitor C1 is charged with the analog input voltage V_{D_P} so that V_{cap}= V_{D_P}, and the V_{cap} voltage may be supplied as the gate voltage of the first transistor TR1 and the second transistor TR2 of the matching block 11. Here, the search line SL is connected with the back gate BG of the first transistor TR1 and the second transistor TR2 comprising the matching block 11 of the first transistor TR1 and/or the second transistor TR2 comprising the matching block 11, such that the threshold voltage of the first transistor TR1 and the second transistor TR2 may decrease or increase depending on the voltage difference between the source voltage V_{SB} and the back gate voltage V_{G} of the first transistor TR1 and/or the second transistor TR2, as shown in the graph of FIG. 3. In FIGS. 2A and 2B, the source voltage V_{SB} is grounded, so the search voltage applied through the search line SL, i.e., the back gate voltage V_{G}, causes the I-V curve to shift as shown in FIG. 2C. Therefore, when the voltages supplied to the search line SL and the data line DL match, they are in a matching state, and when the voltage of the search line SL is greater than the voltage of the data line DL, current I_{D} flows through the first transistor TR1, Conversely, when the search line SL is less than the voltage of the data line DL, current I_{D} flows through the second transistor TR2, and the degree of mismatching may be judged through the current I_{D} flowing.

FIG. 2C is a graph representing an output value of a matching distance based on a voltage difference between a data line and a search line of an analog data similarity search memory element 10 according to one embodiment of the present invention.

Referring to FIG. 2C, by way of non-limitation, the analog data similarity search memory 10 may store a voltage of any one of 0V, 0.2V, 0.4V, 0.6V, 0.8V 1.0V as an analog input voltage (V_{D_P}) in the capacitor C1 based on a total of six threshold voltages. Any one of 0V, 0.2V, 0.4V, 0.6V, 0.8V 1.0V may be provided as an analog search voltage V_{SL} via the search line SL.

It shows the output of the matching distance or drain current I_{D} according to the difference between the analog search voltage V_{SL} supplied to at least one of the second gate terminal G2 of the first transistor TR1 and the fourth gate terminal G4 of the second transistor TR2 defined as the back gate BG and the analog input voltage V_{D_P} formed on the data line DL. For example, when a voltage of 0.6 V is applied through the search line SL and the analog input voltage V_{D_P} supplied to the data line DL is 0.8 V, a drain current I_{D} corresponding to a voltage difference of 0.2 V (0.8 V-0.6 V) flows to the match line ML through the drain terminal D2 of the second transistor TR2, which is an NMOS transistor. Conversely, when a voltage of 0.6 V is applied through the search line SL and the analog input voltage V_{D_P} formed on the data line DL is 0.4 V, the drain current I_{D} corresponding to the voltage difference - 0.2 V (0.4 V-0.6 V) flows to the match line ML through the drain terminal D1 of the first transistor TR1, which is a PMOS transistor. In other words, when V_{D_P} >V_{SL}, the gate voltage becomes positive, and a drain current is generated in the NMOS transistor, and when V_{D_P} < V_{SL}, the gate voltage becomes negative, and a drain current may be generated in the PMOS transistor.

The basic operating principle of the analog data similarity search memory device 10, as shown in FIG. 3, is that the body bias of the transistors TR1 and TR2 is adjusted by a reverse gate voltage V_{BG} to vary the threshold voltage Vₜₕ, the voltage V_{cap} of the capacitor C1 is applied to the gate V_{G} of the transistor, causing the drain current I_{D} of the transistor TR1 or TR2 to flow according to the voltage difference. If V_{cap} = V_{gs} > Vₜₕ, the NMOS transistor TR2 will operate and current will flow, and if V_{cap} = V_{gs} < Vₜₕ, the PMOS transistor TR1 will operate and current will flow. The smaller the difference between the threshold voltage Vₜₕ and V_{gs}, i.e., the degree of matching, the less current flows through the ML at the voltage V_{dd} supplied to the source terminal of the transistor TR1 or TR2.

FIG. 3 is a diagram illustrating the variation of the threshold voltage as a function of the voltage V_{SB} supplied to the reverse bias in an analog data similarity search memory element in accordance with one embodiment of the present invention.

Referring to FIG. 3, the larger the negative reverse bias (+V_{SB}) applied to the nmos transistor TR2, the larger the threshold voltage V_{T}, and the larger the positive reverse bias (-V_{SB}), the smaller the threshold voltage V_{T}. Conversely, if the PMOS transistor TR1 has a negative reverse bias (+V_{SB}), the threshold voltage V_{T} will be smaller, and a positive reverse bias (-V_{SB}), the threshold voltage V_{T} may be larger.

As described above, when the characteristics of the pmos transistor TR1 and the nmos transistor TR2 are ideal, the I-V characteristic graph shown in FIG. 2C shows that when the voltage (V_{G} or V_{D_P} or V_{cap}) of the data line DL and the voltage V_{SL} of the search line SL are matched, the current ID) flowing through the matching line ML is O. However, in practice, due to the different characteristics of the pmos transistor TR1 and the nmos transistor TR2, even when the voltage V_{cap} of the data line DL and the voltage V_{SL} of the search line SL match, an off current I_{off} may flow through the matching line ML to some extent, as shown in (a) of FIG. 7. Therefore, it is necessary to offset the output drain current of the analog data similarity search memory element 10 by the off current I_{off}.

FIG. 4 is an I-V characteristic graph to illustrate how threshold voltage differences between NMOS transistors and PMOS transistors in an analog data similarity search memory device according to one embodiment of the present disclosure may be offset.

Referring to FIG. 4, in the case of the PMOS transistor TR1, since the source is generally grounded (GND) and a negative voltage is applied to the drain, V_{gs} = -V_{g}, an I-V characteristic graph having a threshold voltage as shown in ① may be obtained.

In the ② case, by applying a supply voltage V_{dd} to the source of the PMOS transistor TR1 and grounding the drain GND, only the voltage V_{dd} supplied to the source that is positive compared to η is shifted by to obtain the I-V characteristic graph in red. Therefore, by applying a supply voltage V_{dd} to the source of the PMOS transistor TR1 equal to the difference between the threshold voltage Vₜₕ₋ₚₘₒₛ of the NMOS transistor TR2 and the threshold voltage Vₜₕ₋ₚₘₒₛ of the PMOS transistor TR1, the I-V characteristic graphs of the NMOS transistor TR2 and the PMOS transistor TR1 are symmetrically shifted from each other.

Furthermore, in order for the PMOS transistor TR1 and the NMOS transistor TR2 to obtain a symmetrical I-V characteristic graph, it is necessary to design the channel width of the PMOS transistor TR1, which uses holes with low mobility as carriers, to be larger than that of the NMOS transistor TR2.

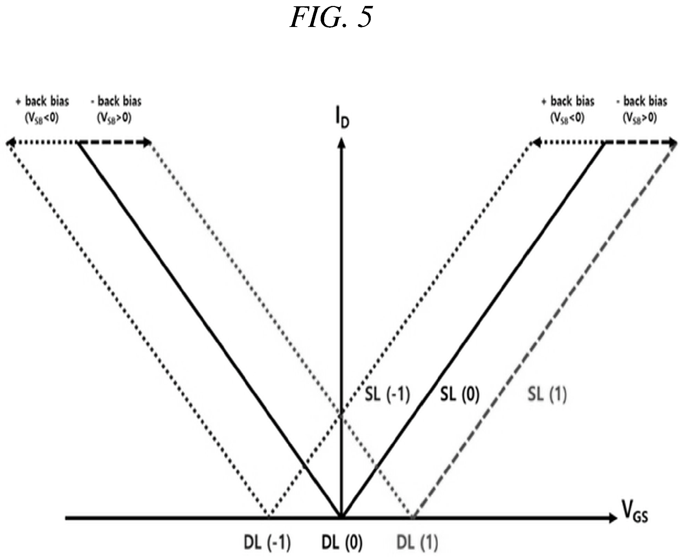

FIG. 5 is an I-V characteristic graph to illustrate the principle of operation of a matching block of an analog data similarity search memory device according to one embodiment of the present invention.

Referring to FIG. 5, non-limitingly, if the data line DL and the search line SL are provided with three different information, -1, 0, and 1, a drain current ID corresponding to the matching distance flows. Assume a negative back bias, i.e., SL = 1 when a positive V_{SB} is applied to the search line SL, and SL = -1 when a negative - V_{SB} is applied to the search line SL. Here, at each SL(-1), SL(0), SL(1), the drain current I_{D} may be zero at the points (DL(-1), DL(0), DL(1)) where the I-V characteristic graphs of the pmos trans jistor TR1 and the nmos transistor TR2 intersect. If DL(-1, 0, 1) and SL(-1, 0, 1) coincide, then the drain current I_{D} may be O. When SL(1) and DL(O), some current flows in the PMOS transistor TR1, and when DL(-1), twice as much current flows as DL(O). On the other hand, when SL(-1) and DL(1), the most current flows through the nmos transistor TR2. Finally, in the case of SL(0) and DL(1), the pmos transistor TR1 is off and only the nmos transistor TR2 is on, while in the case of DL(-1), the pmos transistor TR1 is on and the nmos transistor TR2 is off. In the end, the same current flows through the different transistors if the distance for determining similarity matches. The use of FD-SOI devices rather than conventional bulk CMOS transistors allows for lower leakage current and a larger variation in threshold voltage Vₜ with back bias, making it possible to create devices that may be applied to a wider variety of situations.

In another embodiment, the positions of the drain terminal D1 and the source terminal S1 of the first transistor TR1 in FIGS. 2A and 2B may be changed so that the drain terminal D1 is connected to the supply voltage source V_{dd} and the source terminal S1 is connected to the match line ML. Similarly, the positions of the drain terminal D2 and the source terminal S2 of the second transistor TR2 may be changed so that the drain terminal D2 is connected to the supply voltage source V_{dd} and the source terminal S2 is connected to the match line ML.

As described above, the analog data similarity search memory element 10 comprises fewer elements compared to a conventional 16T CMOS TCAM, resulting in a reduced overall area. Furthermore, a differentiable analog output value (current) is generated through the operation of the distance between successive real values (voltage).

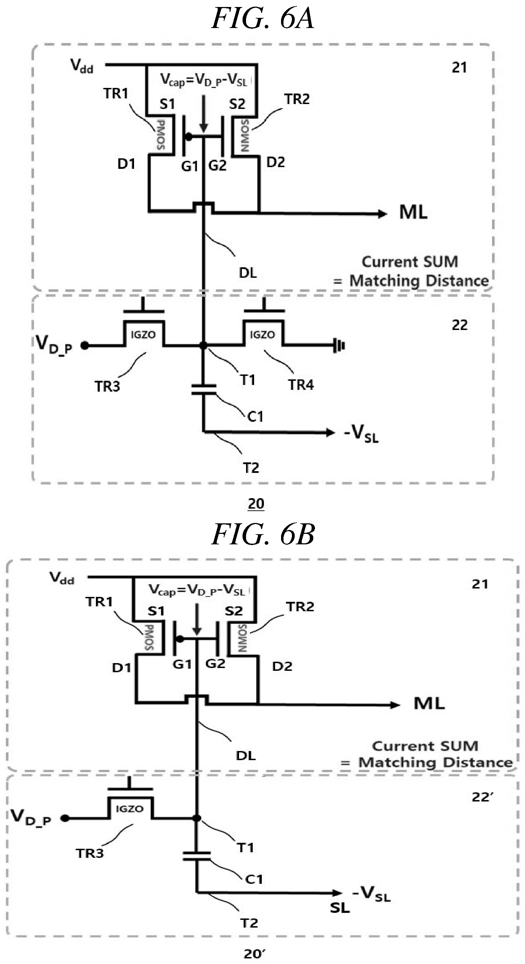

In FIGS. 2A and 2B, a search line SL is connected to a back gate BG of a first transistor TR1 and a second transistor TR2 having a dual gate structure, and a drain current I_{D} is output according to a voltage difference between an analog search voltage V_{SL} supplied through the back gate BG and an analog input voltage V_{D_P} providing a data line DL, The second terminal T2 of the capacitor C1 is connected to the search line SL, as shown in FIGS. 6A and 6B to be described later, The voltage difference between the analog input voltage V_{D_P} supplied to the first terminal T1 of the capacitor C1 and the analog search voltage V_{SL} supplied to the second terminal T2 of the capacitor C1 may be transmitted to the gate terminals of the first transistor TR1 and the second transistor TR2 having a single gate structure.

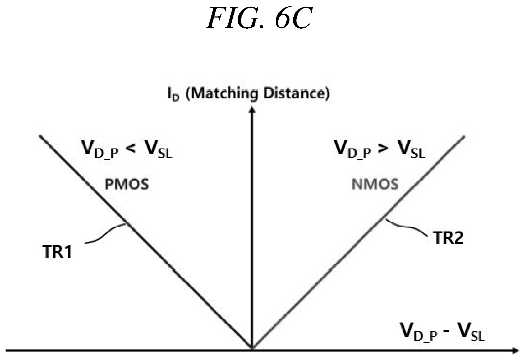

FIGS. 6A and 6B are schematics for an analog data similarity search memory 20, 20' according to another embodiment of the present invention, and FIG. 6C is an I-V characteristic graph of the analog data similarity search memory 20, 20' of FIGS. 6A and 6B.

Referring to FIG. 6A, the analog data similarity search memory 20 may comprise a matching block 21 comprising a first transistor TR1 and a second transistor TR2 having a single gate structure, and a data storage block 22 comprising a third transistor TR3, a fourth transistor TR4, and a capacitor C1.

The first gate terminal G1 of the first transistor TR1 of the matching block 21 and the second gate terminal G2 of the second transistor TR2 connected with the first gate terminal G1 may be connected with the first terminal T1 of the capacitor C1 to form a data line DL. The first drain terminal D1 of the first transistor TR1 and the second drain terminal D2 of the second transistor TR2 connected with the first drain terminal D1 form a match line ML, which may be connected to ground. And the first source terminal S1 of the first transistor TR1 and the second source terminal S2 of the second transistor TR2, which is connected with the first source terminal S2, may be connected with a supply voltage source V_{dd}. Further, the data storage block 22 has a capacitance corresponding to the analog input voltage V_{D_P}, a capacitor C1 including a first terminal T1 defined as a first terminal of the data line DL and a second terminal T2 coupled to the search line SL, and a third transistor TR3 supplying the analog input voltage V_{D_P} to the capacitor C1 and a first terminal of the capacitor C1, may include a fourth transistor TR4 supplying a reference voltage to the capacitor C1.

In FIG. 6A, the matching block 21 and the data storage block 22 are similar to the configuration of the matching block 11 and the data storage block 12 of FIG. 2A, except that the first transistor TR1 and the second transistor TR2 have a single-gate structure, and the search line SL is coupled with the second terminal T2 of the capacitor C1, For a detailed description of the matching block 21 and the data storage block 22, reference may be made to the detailed description of the matching block 11 and the data storage block 12 of FIG. 2A, unless contradictory.

In FIG. 2A, a drain current I_{D} is output according to the voltage difference between the analog search voltage V_{SL} supplied through the back gate BG of the transistors TR1, TR2 and the analog input voltage VD_P of the capacitor C1 supplied through the top gate connected with the data line DL, whereas in FIG. 6A, the first transistor TR1 and the second transistor TR2 have a single gate structure, the search line SL is coupled with the second terminal T2 of the capacitor C1 , and the drain current IDis output according to the voltage difference between the analog input voltage V_{D_P} supplied to the first terminal T1 of the capacitor C1 and the analog search voltage V_{SL} supplied to the second terminal T2 of the capacitor C1, so that FIG. 6A differs from the method of generating the voltage difference in FIG. 2A.

The analog data similarity search memory 20' of FIG. 6B, like FIG. 2B, may omit the fourth transistor TR4 comprising the analog data similarity search memory 20 of FIG. 6A.

FIG. 6C is an I-V characteristic graph of the analog data similarity search memory 20, 20' according to one embodiment of the present invention.

Referring to FIG. 6C, the I-V characteristic graph on the right (red) is shown by the second transistor TR2, which is an NMOS transistor, and the I-V characteristic graph on the left (blue) is shown by the first transistor TR1, which is a PMOS transistor. The x-axis is the voltage difference (V_{cap}= V_{D_P} - V_{SL}) between the analog input voltage V_{D_P} and the analog search voltage V(SL), and the y-axis is the drain current I_{D} flowing through the drain terminal of the first transistor TR1 or the second transistor TR2 to the match line ML, depending on the voltage difference. The larger the absolute value of the voltage difference Vcap, the larger the drain current I_{D}, and the smaller the absolute value of the voltage difference Vcap, the smaller the drain current I_{D}. Ideally, the drain current I_{D} may be zero if the voltage difference Vcap= V_{D_P} - V_{SL} is zero.

FIG. 7 is an illustrative diagram describing the principle of operation for zero offsetting the I-V characteristic graph of the analog data similarity search memory elements 20, 20' according to one embodiment of the present invention.

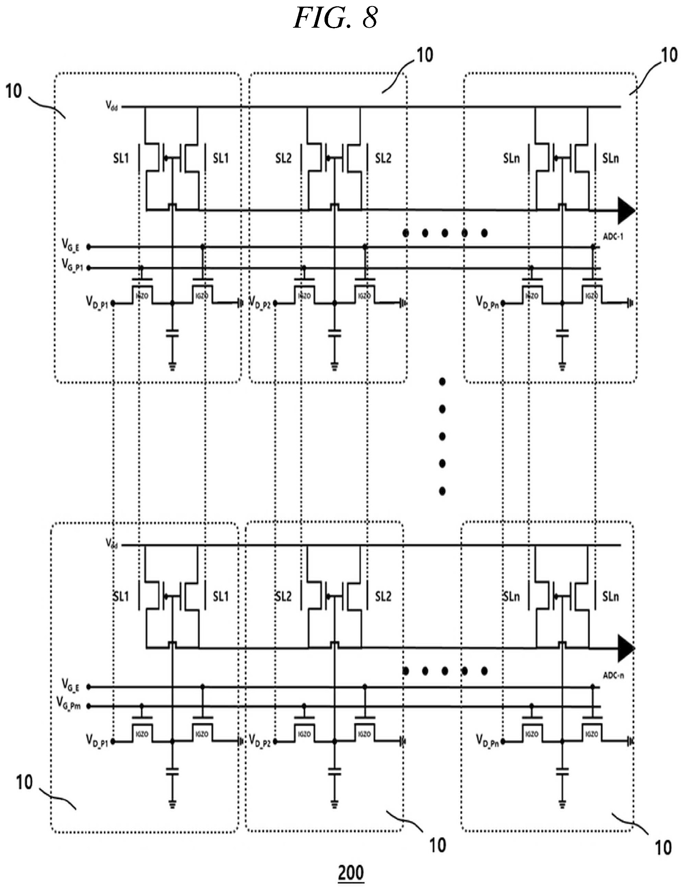

Referring to FIG. 7, an off current I_{off} may flow through the matching line ML even if the voltage V_{D_P} of the data line BL and the voltage V_{SL} of the search line SL are matched (a). When there is only one analog data similarity search memory 20, 20', there is no problem with the off current I_{off} flowing, but since the off current I_{off} may appear differently for each analog data similarity search memory 10 or 20 of the semiconductor memory device 200 comprising the NXM array of analog data similarity search memories 10 of FIG. 8 to be described later, it may be necessary to zero offset the I-V characteristic graph of the analog data similarity search memories 10, 20 as shown in (b).

To zero offset the I-V characteristic graph of the data similarity search memory element, the fourth transistor TR4 of the data storage blocks 12, 22 described above may be used. Specifically, the fourth transistor TR4 is first turned on so that 0 V is applied to the first terminal T1 of the capacitor C1. Then, the fourth transistor TR4 is turned off so that only the I_{off} current is subtracted by while the first terminal T1 of the capacitor C1 is fixed at 0 V, so that the I-V characteristic graphs of the data similarity search memory elements 10, 20 may be offset to zero.

FIG. 8 is a schematic diagram of a semiconductor memory device 200 comprising a MXN array of analog data similarity search memory elements according to one embodiment of the present invention. A schematic diagram and detailed description of each analog data similarity search memory element 10 may be found with reference to FIGS. 2A and 2B above. Referring to FIG. 8, the semiconductor memory device 200 may comprise an NXM array of analog data similarity search memory elements 10. The N analog data similarity search memory elements 10 in the first row may store and update real vector values representing feature points of the first training image, i.e., the N real values are defined as a vector array, and the N real values are each stored in the analog data similarity search memory elements 10. Similarly, the N analog data similarity search memory elements 10 in the second row may store and update the real vector values representing the feature points of the second training image. The N analog data similarity search memory 10 of the Mth row may store and update real vector values representing feature points of the Nth training image.

In an array environment with MXN analog data similarity search memory elements 10, the data line DL updates are programmed sequentially row by row. In the case of programming a 1XN dimensional real vector extracted by training a specific image in the CNN to the first row, the real vector value may be programmed by applying a respective V_{D_P} voltage. In this case, only the voltage V_{G_P} of the first column to be programmed is applied, and the remaining columns are not programmed. If the same voltage is applied to each search line SL and data line DL, the distance difference between the search line SL and data line DL is 0V, so the current value through the ADC may be almost zero. If it is not zero, the problem may be solved by adding a write/verify process that changes the value of V_{D_P} in the corresponding column while converging to '0'. When updating the data lines DL, you may program a total of m rows sequentially, read the distance, and then reset the data by turning on V_{G_E} in all columns before updating the data.

Furthermore, the read operation is performed simultaneously in all analog data similarity search memory elements 10 in parallel. After the data storage blocks 12 of all analog data similarity search memory elements 10 are updated, the real vector values extracted from the 1XN dimensional query image are applied to each SL₁ to SLₙ simultaneously. At this time, V_{dd} may be set to a value equal to the difference between the threshold voltage (Vₜₕ) of the nmos transistor and the pmos transistor as shown in FIG. 4 above. Following the parallel read operation, the voltage difference between the data line DL and the search line SL is read from each analog data similarity search memory element 10, so that the sum of the distance values (currents) output from the n analog data similarity search memory elements 10 for each row is provided to the ADC. By reading the distance values output from each row in a total of m ADCs, the value with the smallest distance may be determined as the matching image. In this case, unlike conventional TCAMs, the distance may be calculated as an analog value, so the distance value may be used for backpropagation when applied to the loss function.

In FIG. 8, analog data similarity search memory element 10 may be replaced by analog data similarity search memory elements 10', 20, 20'.

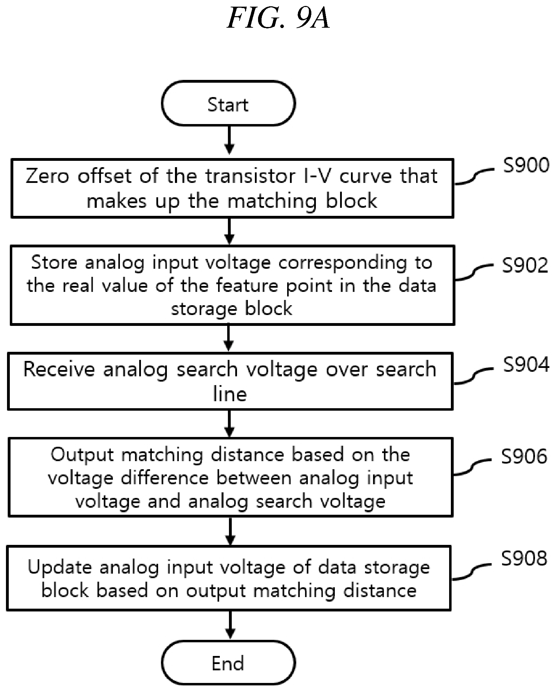

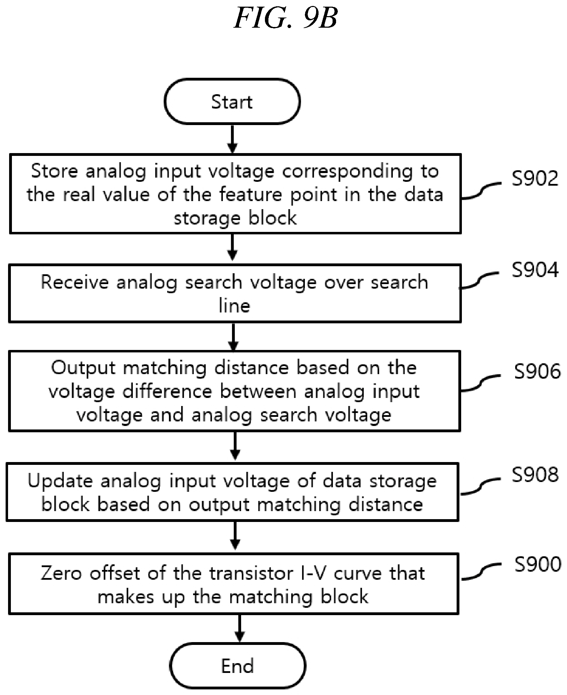

FIGS. 9A and 9B are flow diagrams to illustrate a method of operation of an analog data similarity search memory element according to one embodiment of the present invention.

Referring to FIG. 9A, a method of operation of an analog data similarity search memory device comprising: a data storage block in connection with a first terminal of a data line; and a matching block in connection with a search line and a match line and in connection with a second terminal of the data line, the method comprising: a step S900 of performing a zero point offset of the I-V curves of the transistors comprising the matching block as shown in FIG. 7; storing an analog input voltage corresponding to a real value of a corresponding feature point in the data storage block S902; receiving an analog search voltage via a search line S904; and outputting an analog matching distance value corresponding to a voltage difference between the analog input voltage and the analog search voltage via a match line S908. The voltage difference between the analog input voltage and the analog search voltage may be generated via the data line. Optionally, the method may further include the step of backpropagating the analog matching distance value to update the analog input voltage of the data storage block. The analog matching distance value may be easily utilized for backpropagation in contrast to the prior art because it represents the distance between successive input data (or voltages) in the form of a differentiable current.

On the other hand, the step S900 of performing the zero point offset of the configuring transistor I-V curve may be processed in parallel with other steps, and may be performed after the step S908 of outputting the analog matching distance value via the match line, as shown in FIG. 9B. Unless contradicted, the detailed description of FIG. 9B may be referred to the description of FIG. 9A.

As described above, the present invention relates to a CMOS-based similarity memory having an I-V characteristic graph that mimics an implementation of the Euclidean distance function, enabling parallel distance operations between data vectors. In addition, it may be utilized as a differentiable computing hardware resource by performing distance operations between data vectors consisting of continuous values rather than binary values, and may be applied in-situ for training neural networks to streamline computing.

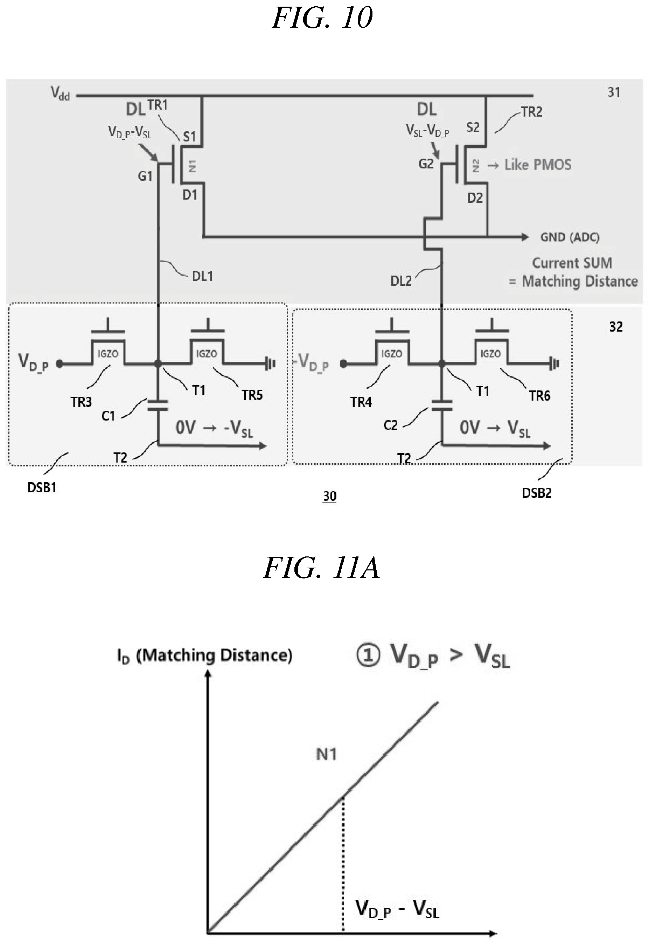

FIG. 10 is a schematic diagram for an analog data similarity search memory device 30, according to another embodiment of the present invention.

Referring to FIG. 10, the analog data similarity search memory 30 may comprise a matching block 31 and a data storage block 32. The analog data similarity search memory 30 may perform a matching distance operation between the data stored in the data storage block 32 and the search data input through the matching block 31, and may output the distance between successive input data (or voltages) in the form of a differentiable current.

The matching block 31 may comprise a first transistor TR1 and a second transistor TR2. The data storage block 32 may include a first sub-data storage block DSB1 associated with the first transistor TR1 and a second data storage block DSB2 associated with the second transistor TR2. The first sub-data block DSB1 has a first capacitance value corresponding to a first analog input voltage V_{D-P}, a first capacitor C1 including a first terminal T1 defined as a first terminal of the first data line DL1 and a second terminal T2 coupled to the search line SL, and a third transistor TR3 coupled to the first terminal T1 of the first capacitor C1 and supplying the first analog input voltage V_{D-P} to the first capacitor C1. Similarly, the second sub-data block (DSB2) may have a second capacitance value corresponding to the second analog input voltage (-V_{D-P}), a second capacitor C2 including a first terminal T1 defined as a first terminal of the second data line DL2 and a second terminal T2 coupled to the search line SL, and a fourth transistor TR4 coupled to the first terminal T1 of the second capacitor C2 and supplying the second analog input voltage (-V_{D-P}) to the second capacitor C2.

Optionally, the first data storage block DSB1 is connected to the first terminal T1 of the first capacitor C1 and may further comprise a fifth transistor TR5 supplying a reference voltage (e.g., OV) to the first capacitor C1. Similarly, the second data storage block DSB2 is connected to the first terminal T1 of the second capacitor C2, and may further include a sixth transistor TR6 that supplies the reference voltage (e.g., OV) to the second capacitor. The I-V curves of the transistors comprising the matching block may be zeroed offset by means of an off current I_{off} output based on the reference voltage in the aforementioned FIG. 7.

Further, the first gate terminal G1 of the first transistor TR1 may be connected with the first terminal T1 of the first capacitor C1 to form a first data line DL1, and the second gate terminal G2 of the second transistor TR2 may be connected with the first terminal T1 of the second capacitor C2 to form a second data line DL2. Further, the first drain terminal D1 of the first transistor TR1 and the second drain terminal D2 of the second transistor TR2 connected with the first drain terminal D1 form a match line ML, which may be connected to ground. The first source terminal S1 of the first transistor TR1 and the second source terminal S2 of the second transistor TR2, which is connected with the first source terminal S2, may be connected with a supply voltage source V_{dd}. Non-limitingly, the first transistor TR1 and the second transistor TR2 may both be NMOS (N-type MOSFET) transistors, and the third transistor TR3, the fourth transistor TR4, the fifth transistor TR5, and the sixth transistor TR6 may be IGZO (InGaZnO) transistors.

In FIGS. 6A and 6B, the matching block 21 is configured with a PMOS (P-type MOSFET) transistor and an NMOS (N-type MOSFET) transistor, whereas in FIG. 10, the matching block 31 is configured with two NMOS (N-type MOSFET) transistors.

As mentioned above, the analog matching distance values output from the matching blocks 21, 31 may be backpropagated to update the analog input output voltages stored in the data storage blocks 22, 32.

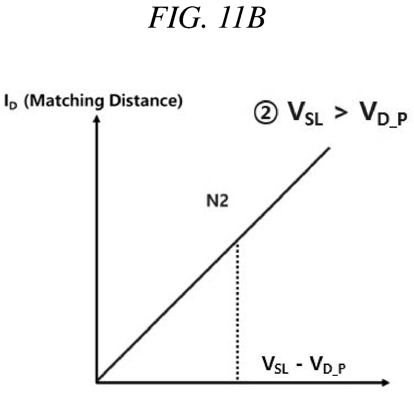

FIGS. 11A and 11B are I-V characteristic graphs of the analog data similarity search memory element 30 according to another embodiment of the present invention.

Referring to FIG. 11A, it is an I-V characteristic graph of the first transistor TR1, wherein the analog input voltage V_{CAP} or V_{D-P} stored in the data storage block 32 is greater than the analog search voltage V_{SL} applied through the search line SL coupled to the second terminal T2 of the capacitor C1, C2 is greater than the analog search voltage VSL applied through the search line SL coupled with the second terminal T2 of the capacitor C1, C2, the first transistor TR1 operates, and the first transistor TR1 may supply a drain current I_{D} to the match line ML equal to the voltage difference between VCAP- VSL.

Referring to FIG. 11B, an I-V characteristic graph of the second transistor TR2, when the analog search voltage VSL applied through the search line SL coupled to the second terminal T2 of the capacitors C1, C2 is greater than the analog input voltage V_{CAP} or V_{D-P} stored in the data storage block 22, the second transistor TR2 is operated, and the second transistor TR2 may supply a drain current I_{D} to the match line ML equal to the voltage difference between V_{SL}- V_{CAP} P.

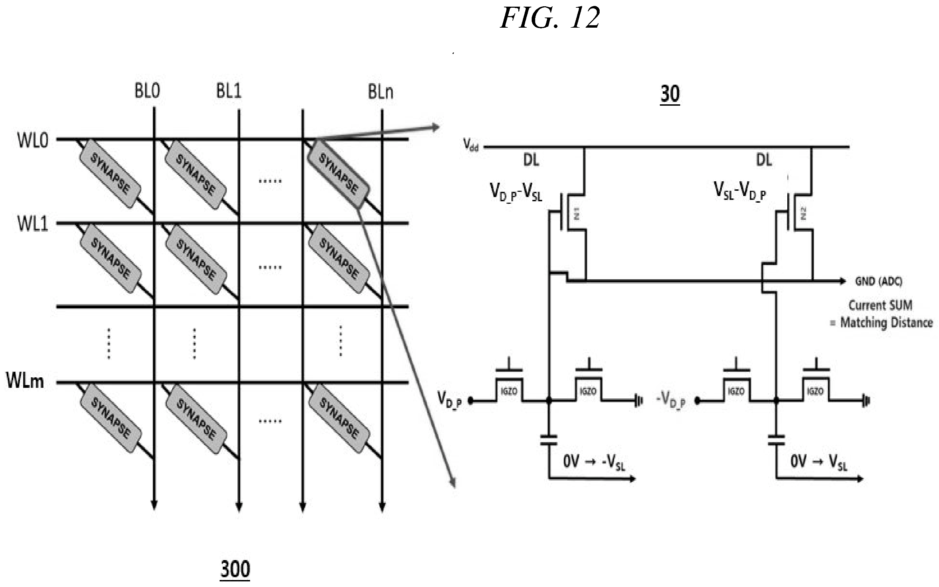

FIG. 12 is a schematic of a semiconductor memory device 300 comprising an NXM array of analog data similarity search memory elements 20 according to another embodiment of the present invention. A schematic and detailed description of each of the analog data similarity search memory elements 30 may be found with reference to FIG. 10.

Referring to FIG. 12, the semiconductor memory device 300 may comprise an NXM array of analog data similarity search memory elements 30. The N analog data similarity search memory elements 30 in the first row may store and update real vector values representing feature points of the first training image, i.e., the N real values are defined as a vector array, and the N real values are each stored in the analog data similarity search memory elements 30. Similarly, the N analog data similarity search memory elements 30 in the second row may store and update real vector values representing feature points of the second training image. The N analog data similarity search memory elements 30 of the Mth row may store and update real vector values representing feature points of the Nth training image. Word lines WL₀ to WLₘ are connected to transistors TR3, TR4 of the data storage block 22 of the analog data similarity search memory 20, which may apply analog input voltages corresponding to the feature points of the training images to the data storage block 32. The bit lines BL₀ to BLₙ are connected to a search line SL coupled to the second terminal T2 of the capacitors C1, C2, such that an analog search voltage is applied to the second terminal T2 of the capacitors C1, C2.

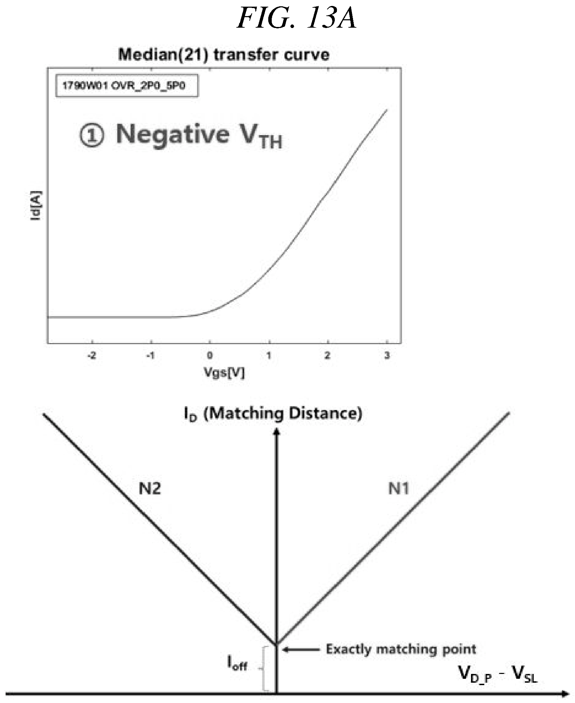

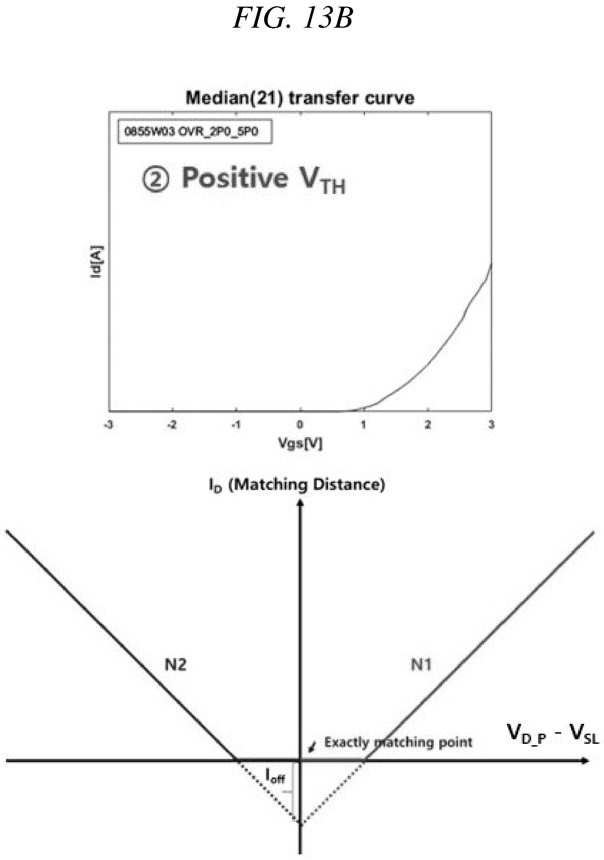

FIGS. 13A and 13B are illustrative drawings describing the principle of operation of an analog data similarity checker that zeroes off the I-V characteristic graph of a color memory device, according to one embodiment of the present invention.

Referring to FIG. 13A, depending on the device characteristics, the first transistor TR1 and the second transistor TR2 may have a negative threshold voltage (V_{TH}). At this time, as previously mentioned in FIG. 7, an off current I_{off} may occur in the analog data similarity search memory element 20, and a positive off current I_{off} may appear.

Referring to FIG. 13B, depending on the characteristics of the device 30, the first transistor TR1 and the second transistor TR2 may have a positive threshold voltage V_{TH}. At this time, as previously mentioned in FIG. 7, an off current I_{off} may occur in the analog data similarity search memory element 30, and a negative off current I_{off} may appear. The off current I_{off} is the value of the drain current I_{D} that flows when a reference voltage (0 V) is applied to the capacitors C1, C2 of the data storage block 22 and then OV is applied to the transistors TR1, TR2 of the match block ML.

In an environment where the zero point offset of the I-V characteristic graph of the analog data similarity search memory 30 is taken into account, the matching distance of the semiconductor memory device 300 comprising the NXM array of the analog data similarity search memory 30 of FIG. 12 may be calculated as shown in the following [Equation 1]. [Equation 1] $\begin{matrix}Matching Distance = \\ {I}_{SUM \left(WLn\right)} - {\sum }_{k = 0}^{n} {I}_{off \left(WLn, BLk\right)} \\ = K \left(Vcap-VSL-Vth\right) - K \left(-Vth\right) \\ = K \left(Vcap-VSL\right)\end{matrix}$

Where I_{sum(WLn)} is the sum of the drain currents I_{D} output from the N analog data similarity search memory elements 20 connected to the wordlines WLn, and I_{off} is an off current determined based on the reference voltage, Vcap is the analog input voltage stored in the capacitors C1, C2 of the data storage block 22, V_{SL} is the analog search voltage applied through the search line SL, Vₜₕ is the threshold voltage of the transistor, and K is a constant value.

This specification discloses preferred embodiments of the present invention, and although certain terms are used, they are used in a general sense to facilitate the description and understanding of the invention and are not intended to limit the scope of the invention. In addition to the embodiments disclosed herein, other modifications based on the technical ideas of the present invention will be apparent to one of ordinary skill in the art to which the present invention belongs.. One of ordinary skill in the art will recognize that the embodiments described with reference to FIGS. 1 through 13B, including the analog data similarity search memory elements, methods of operating the analog data similarity search memory elements, and semiconductor memory devices comprising arrays of analog data similarity search memory elements, may be subject to various substitutions, changes, and modifications without departing from the technical ideas of the present invention. By way of specific example, while the foregoing embodiments have been described primarily with respect to the case where the transistors in the matching block 11 are PMOS and NMOS transistors and the transistors in the data storage device 12 include IGZO transistors, ferroelectric transistors other than PMOS and NMOS transistors may be used, and resistive RAM (RRAM) or phase change RAM (PRA) other than IGZO transistors may be used. The scope of the invention is therefore not limited by the embodiments described, but rather by the technical ideas recited in the patent claims.

### [Explanation of symbols]

10, 20, 30: Analog Data Similarity Search Memory
11, 21, 31: Matching blocks
12, 22, 32: Data storage blocks
200, 300: Semiconductor memory device

### INDUSTRIAL APPLICARILITY

The present invention relates to an analog data similarity search memory device and a method of operating the same, and is industrially available.

## Claims

1. An analog data similarity search memory device, comprising:
a data storage block that stores an analog input voltage and is connected to a first terminal of a data line; and
a matching block comprising a match line connected to a second terminal of the data line and outputting an analog matching distance value corresponding to a voltage difference between the analog input voltage and an analog search voltage applied via search line, and
wherein the voltage difference between the analog input voltage and the analog search voltage is generated via the data line.

2. The analog data similarity search memory device of claim 1,
wherein the matching block comprises a first transistor having a first dual gate and a second transistor having a second dual gate, and
the data storage block comprises a capacitor including a first terminal of the data line and a second terminal connected to ground, and a third transistor connected to the first terminal of the capacitor and supplying the analog input voltage to the capacitor.

3. The analog data similarity search memory device of claim 2,
wherein the data storage block comprises:
further a fourth transistor connected to the first terminal of the capacitor and supplying a reference voltage to the capacitor, and
wherein the I-V curves of the transistors of the matching block are zero-offset according to an off current (I_{off}) output based on the reference voltage.

4. The analog data similarity search memory device of claim 2,
wherein the first gate terminal of the first transistor and a third gate terminal of the second transistor are connected with the first gate terminal of the capacitor to form the data line, and
wherein the second gate terminal of the first transistor and a fourth gate terminal of the second transistor are connected with the search line.

5. The analog data similarity search memory device of claim 2,
wherein the first drain terminal of the first transistor and the second drain terminal of the second transistor connected with the first drain terminal form the match line, and are connected to ground.

6. The analog data similarity search memory device of claim 2,
wherein the first source terminal of the first transistor and the second source terminal of the second transistor connected to the first source terminal are connected to a supply voltage source, and
wherein the voltage supplied from the supply voltage source offsets a difference between a first threshold voltage of the first transistor and a second threshold voltage of the second transistor.

7. The analog data similarity search memory device of claim 2 or claim 3, wherein the first transistor is a PMOS (P-type MOSFET) transistor, the second transistor is an NMOS (N-type MOSFET) transistor, and the third transistor and the fourth transistor are IGZO (InGaZnO) transistors.

8. The analog data similarity search memory device of claim 1, wherein the analog matching distance value is larger for a larger difference between the analog input voltage and the analog search voltage, and smaller for a smaller difference between the analog input voltage and the analog search voltage.

9. The analog data similarity search memory device of claim 1,
wherein the matching block comprises a first transistor and a second transistor, and
wherein the data storage block comprises a capacitor having a capacitance corresponding to the analog input voltage, the capacitor including a first terminal of the data line and a second terminal connected to the search line, and a third transistor connected to the first terminal of the capacitor and supplying the analog input voltage to the capacitor.

10. The analog data similarity search memory device of claim 9,
wherein the data storage block further comprises
a fourth transistor connected to the first terminal of the capacitor and supplying a reference voltage to the capacitor, and
wherein the I-V curves of the transistors comprising the matching block are zero-offset according to an off current (I_{off}) output based on the reference voltage.

11. The analog data similarity search memory device of claim 9,
wherein a first gate terminal of the first transistor and a second gate terminal of the second transistor connected with the first gate terminal are connected with a first terminal of the capacitor to form the data line, and
wherein a first drain terminal of the first transistor and a second drain terminal of the second transistor connected to the first drain terminal form a match line, the match line being connected to ground.

12. The analog data similarity search memory device of claim 9,
wherein a first gate terminal of the first transistor and a second gate terminal of the second transistor connected with the first gate terminal are connected to a supply voltage source, and
wherein the voltage supplied from the supply voltage source offsets a difference between a first threshold voltage of the first transistor and a second threshold voltage of the second transistor.

13. The analog data similarity search memory device of claim 9 or claim 10,
wherein the first transistor is a PMOS (P-type MOSFET) transistor, the second transistor is an NMOS (N-type MOSFET) transistor, and the third transistor and the fourth transistor are IGZO (InGaZnO) transistors.

14. The analog data similarity search memory device of claim 1,
wherein the matching block comprises a first transistor and a second transistor, and
the data storage block includes a first sub-data storage block associated with the first transistor and a second sub-data storage block associated with the second transistor, and
wherein the first sub-data block comprises a first capacitor including a first terminal of the first data line and a second terminal coupled to the search line, and a third transistor connected to the first terminal of the first capacitor and supplying the first analog input voltage to the first capacitor, and
the second sub-data block comprises a second capacitor including a first terminal of a second data line and a second terminal coupled to the search line, and a fourth transistor coupled to the first terminal of the second capacitor and supplying the second analog input voltage to the second capacitor.

15. The analog data similarity search memory device of claim 14,
wherein the first data storage block is connected to a first terminal of the first capacitor and further comprises a fifth transistor supplying a reference voltage to the first capacitor, and
wherein the second data storage block is connected to a first terminal of the second capacitor and further comprises a sixth transistor supplying a reference voltage to the second capacitor, and
wherein the I-V curves of the transistors comprising the matching block are zero-offset by using a reference analog matching distance value output based on the reference voltage.

16. The analog data similarity search memory device of claim 14,
wherein a first gate terminal of the first transistor is connected with a first terminal of the first capacitor to form the first data line, and a third gate terminal of the second transistor is connected with a first terminal of the second capacitor to form the second data line, and
wherein a first drain terminal of the first transistor and a second drain terminal of the second transistor connected with the first drain terminal form the match line, and are connected to ground.

17. The analog data similarity search memory device of claim 14,
wherein a first gate terminal of the first transistor and a second gate terminal of the second transistor connected with the first terminal are connected to a supply voltage source, and
wherein the voltage supplied from the supply voltage source offsets a difference between a first threshold voltage of the first transistor and a second threshold voltage of the second transistor.

18. The analog data similarity search memory device of claim 14 or claim 15, wherein the first transistor and the second transistor are N-type MOSFET (NMOS) transistors, and wherein the third transistor, the fourth transistor, the fifth transistor, and the sixth transistor are InGaZnO (IGZO) transistors.

19. The analog data similarity search memory device of claim 1, wherein the analog matching distance value is backpropagated and used to update an analog input voltage of the data storage block.

20. A semiconductor memory device comprising an array of analog data similarity search memory devices as recited in claim 1.

21. A method of operating an analog data similarity search memory device comprising: a data storage block connected with a first terminal of a data line; and a matching block in connection with a search line and a match line and connected with a second terminal of the data line, comprising:
storing in the data storage block an analog input voltage corresponding to a real value of a corresponding feature point;
receiving an analog search voltage via the search line; and
outputting an analog matching distance value via a match line corresponding to a voltage difference between the analog input voltage and the analog search voltage, and
wherein a voltage difference between the analog input voltage and the analog search voltage is generated via the data line.

22. The method of claim 21, further comprising:
performing a zero-offset of the I-V curves of transistors including the matching block.

23. The method of claim 21, further comprising:
updating an analog input voltage of the data storage block by backpropagating the analog matching distance value.
